# EUROPEAN PATENT SPECIFICATION

(11) **EP 3 750 194 B1**
(45) Date of publication and mention of the grant of the patent: **06.07.2022**
(21) Application number: 19707709.2
(22) Date of filing: 08.02.2019
(51) Int. Cl.: H01L 37/02, H01L 35/28, H01L 35/34

(54) **ELECTRIC POWER GENERATOR CONTAINING AN ACTIVE MATERIAL**
STROMGENERATOR MIT AKTIVEM MATERIAL
GÉNÉRATEUR D'ÉNERGIE ÉLECTRIQUE CONTENANT UN MATÉRIAU ACTIF

(30) Priority: 09.02.2018 IT 201800002541
(43) Date of publication of application: 16.12.2020
(73) Proprietor: TERMO-IND SA, 6830 Chiasso (CH)
(72) Inventor: MAGAGNIN, Luca, 20017 RHO (IT); TIRELLA, Vincenzo, 6877 COLDRERIO (CH); ACCOGLI, Alessandra, 73030 DISO (IT); PANZERI, Gabriele, 20872 CORNATE D'ADDA (IT); GIBERTINI, Eugenio, 20090 CUSAGO (IT); SUCCA, Luca, 00125 ROMA (IT); BRUNETTI, Simone, 00126 ROMA (IT)
(74) Representative: Cattaneo, Elisabetta
(86) International application number: PCT/EP2019/053183
(87) International publication number: WO 2019/155011

(56) References cited:
- EP-A1- 3 002 269
- EP-A1- 3 002 272
- JP-A- 2004 363 553
- US-A1- 2014 227 548

## Description

### FIELD OF THE INVENTION

The present invention relates to an active material to be used for the manufacturing of an electric generator and to a method for obtaining such medium. The present invention hence relates also to an electric generator comprising said active material.

### STATE OF THE ART

It is widely known the use of thermoelectric power generators and thermionic power generators for the conversion of thermal energy directly into electrical energy.

The thermoelectric power generators are devices based on a thermoelectric effect, namely the Seebeck effect, involving interactions between the flow of heat and of electricity between solid bodies. Examples of such devices are disclosed in the patent EP 2521192 and in the patent application EP 2277209. In broad terms, thermoelectric power generators consist of three main components: thermoelectric material, thermoelectric modules and thermoelectric system that interface with a heat source.

Thermoelectric materials generate power directly from heat by converting temperature differences into electric voltage. In particular, these materials typically have both high electrical conductivity and low thermal conductivity. The low thermal conductivity ensures that when one side is made hot, the other side stays cold. This helps to generate a large voltage while in a temperature gradient.

A thermoelectric module is a circuit containing thermoelectric materials which generate electricity from heat directly. A module consists of two dissimilar thermoelectric materials joining at their ends, namely a negatively charged semiconductor and a positively charged semiconductor. A direct electric current will flow in the circuit when there is a temperature gradient between the two materials. Such gradient is provided by the thermoelectric system which typically comprise heat exchangers used on both sides on the module to supply respectively heating and cooling.

Thermionic power generators, also called thermionic power converters, convert heat directly into electricity. A thermionic power generator typically comprises two electrodes arranged in a containment. One of these is raised to a sufficiently high temperature to become a thermionic electron emitter or "hot plate". The other electrode is called collector because it receives the emitted electrons. The collector is operated at significantly lower temperature. The space between the electrodes can be vacuum or alternatively filled with a vapour gas at low pressure. The thermal energy may be supplied by chemical, solar or nuclear sources.

Thermoelectric power generators as well as thermionic power generators have many drawbacks, among which the low conversion efficiency and the need of providing a temperature gradient. In addition, such generators, require relatively constant thermal source.

Therefore, it is the primary object of the present invention to provide an electric power generator capable to convert part of the thermal energy in electric energy and allowing to overcome the drawbacks of the devices of the prior art

### SUMMARY OF THE INVENTION

The inventors surprisingly found out a new active material capable to be applied on one electrode and to generate current when comprised between at least two electrodes without initial charging and dependently on the temperature. Therefore, the present invention relates to an electric power generator according to the independent device claim 1.

In the present invention when the term "plasticizer additive" is used, it is meant a substance capable to produce or promote plasticity when added, for example silicone, siloxanes or Carnauba Wax, but Naphtalene, PVDF, Parylene, PTFE, FEP, PDMS, PVA, latex-based suspensions and biopolymers can also be contemplated. In the present invention when it is referred to the "particle size" of the at least one oxygen-containing compound it is meant the average diameter of said particle as measured with Scanning Electron Microscope (SEM), Transmission Electron Microscope (TEM) or Dynamic Light Scattering (DLS).

In a preferred embodiment the active material of the invention comprises a further oxygen-containing compound selected from MgO, ZnO, ZrOCl₂, ZrO₂, SiO₂, Bi₂O₃, Al₂O₃, TiO₂ and their mixture, said further oxygen-containing compound having an average diameter in the range from 10 nm to 40 µm. The EPG comprises active material according to the invention between the at least two electrodes. Therefore the invention relates to an EPG comprising at least a first electrode and at least a second electrode, wherein the electric power generator comprises an active material according to the invention between said electrodes. The electrodes are made of metals, alloys and/or carbon-based materials like graphite. Electrodes thickness ranges preferably from 0.1 to 3000 µm, more preferably from 50 to 1000 µm, still more preferably from 300 to 600 µm. In a preferred embodiment of the EPG according to the invention, the at least two electrodes are made of Cu and Al, preferably in form of plates or foils substantially parallel. In case of flexible EPG both self-standing flexible materials (among the previous listed materials) and metallized polymers can be considered as electrodes.

The present invention also relates to a power generator module (PGM) comprising a plurality of EPG which can be connected in series or parallel without comprising the EPG characteristics (voltage and current).

### DESCRIPTION OF FIGURES

Further features and advantages of the invention will be more apparent in light of the detailed description of the active material and of the preferred embodiments of the electric power generator with the aid of enclosed drawings in which:
- Figure 1 shows the sandwich structure of the electric power generator comprising the active material according to the present invention;
- Figures 1A and 1B show respectively a first embodiment and a second embodiment of a power generator module (PGM) comprising a plurality of EPG according to the present invention;
- Figure 2 shows an example of an electrical circuit comprising the electric power generator according to the present invention;
- Figure 2A and 2B show a circuit comprising the PGM of the invention according to example 14, respectively during charging phase (figure 2A) and discharging phase (figure 2B);
- Figure 2C show a circuit comprising the EPG and the potentiostat/galvanostat used in example 13;
- Figure 3 shows an example of an electrical circuit comprising the electric power generator according to the present invention;
- Figure 4 shows the curve of the results of the test carried out in example 9;
- Figure 5 shows the curve of the result of the tests carried out in example 10;
- Figure 6 shows the curve of the results of the test carried out in example 11; and
- Figure 7 shows the results of the test carried out in Example 12.

### DETAILED DESCRIPTION OF THE INVENTION

The present invention hence relates to an active material in an electric power generator comprising at least one oxygen-containing compound selected from Fe₃O₄ and Fe₂O₃, at least one thickener additive selected from the group consisting of agar agar, xanthan gum, methylcellulose, and arabic gum, and at least one plasticizer additive, wherein the particle size of the at least one oxygen-containing compound has an average diameter in the range from 10 nm to 40 µm.

In the active material of the invention the at least one oxygen-containing compound has a particle size corresponding to an average diameter in the range from 10 nm to 40 µm.

Preferably, the active material comprises Fe₃O₄ and Fe₂O₃.

In a preferred embodiment the active material of the invention comprises a further oxygen-containing compound selected from MgO, ZnO, ZrOCl₂, ZrO₂, SiO₂, Bi₂O₃, Al₂O₃, TiO₂ and their mixture, said further oxygen-containing compound having an average diameter in the range from 10 nm to 40 µm.

Particles size of the at least one oxygen-containing compound and of the further oxygen-containing compound have an average diameter in the range from 10 nm to 40 µm, preferably in the range of 20 nm-10 µm, more preferably 10 nm - 5 µm. More preferably, the particles size of of the at least one oxygen-containing compound and of the further oxygen-containing compound has an average diameter in the range from 10-200 nm, still more preferably in the range of 15-100 nm, still more preferably 20-40 nm.

The active material comprises preferably one oxygen-containing compound selected from Fe₃O₄ and Fe₂O₃ preferably in the weight percentage in the range from 3% and 17%, preferably 10% with respect to the total weight of the active material.

The active material preferably comprises Fe₃O₄ and Fe₂O₃ together with further oxygen-containing compounds, i.e. MgO, ZnO and ZrO₂ as oxygen-containing compounds, more preferably each one in the weight percentage in the range from 0.7% and 20%, still more preferably 3.7% with respect to the total weight of the active material.

The active material of the electric power generator comprises at least one thickener additive selected from the group consisting of agar agar, xanthan gum, methylcellulose, and arabic gum. Preferably, the active material comprises agar agar, Xanthan gum, and/or methylcellulose as thickener additives, more preferably each one in the weight percentage in the range from 0.19% and 6.5 %, still more preferably 0.84 % with respect to the total weight of the active material.

The active material comprises also at least one plasticizer additive. The at least one plasticizer additive is preferably selected from the group consisting of silicone, siloxanes, Carnauba Wax, Naphtalene, PVDF, Parylene, PTFE, FEP, PDMS, PVA, latex based suspensions and biopolymers.

Without being bound to any theory, the inventors reasonably thought that the combined use of these materials, i.e. the at least one plasticizer with the at least one oxygen-containing compound of the invention could enhance the performances of materials and hence of the electric power generator containing it, thus improving the results obtained under particular regimes.

More preferably the at least one plasticizer is silicone, still more preferably in an amount in the range from 5 to 60%, preferably 12.5% and 37.5%, still more preferably 33.3% by weight with respect to the total weight of the gelled material. The gelled material is obtained after the step d) of the process of the invention as it will be clearer below.

The active material of the electric power generator, wherein at least one plasticizer additive is silicone in an amount in the range from 5% to 80%, preferably 12.5% and 70%, more preferably 40% with respect to the total weight of the active material. The active material comprises also at least one plasticizer additive with respect to the weight of the gelled material in the range from 1:4 to 3:2, still more preferably in a ratio of 1:3.

The active material can comprise further compounds, preferably Antrachene, PZT materials, and Si3N4.

The active material can be anhydrous or can contain a certain amount of the water deriving from the process for preparing it. In preferred embodiment, the process provides for eliminating the excess water, thus guaranteeing that it still present, as absorbed coordinated water, in a percentage of at least 1% respect to the final active material's total mass.

The inventors deem that such a percentage of coordinated water in the final active material can ameliorate the performances of the final devices obtained by incorporating the active material. The active material can also contain further additives. Additives may be water coordination additives, casein can be cited.

In a preferred embodiment of the invention, the active material comprises Fe₃O₄ and Fe₂O₃ as oxygen-containing compounds, agar agar, Xanthan gum, methylcellulose as thickener additives and silicone as plasticizer additive, wherein the particle size of the oxygen-containing compound has an average diameter in the range from 10 nm to 40 µm.

In another aspect, a process not forming part of the invention for preparing the active material comprising the following steps:
a) preparing a solution of at least one oxygen-containing compound selected from Fe₃O₄ and Fe₂O₃ with a solvent selected from the group consisting of water, ethylene glycole, Dimethyl carbonate, Ethylene carbonate, Diethyl carbonate, Propylen carbonate, glycerin, dimethyl sulfoxide and relative mixtures;
b) heating the solution of step a) at a temperature in the range from 75 to 90°;
c) adding at least one thickener additive selected from the group consisting of agar agar, xanthan gum, methylcellulose, and arabic gum thus obtaining a homogeneous solution;
d) cooling down the homogenous solution of step c) to a temperature in the range from 30°C to 15°C, thus obtaining a gelled material;
e) adding at least one plasticizer additive selected from the group consisting of silicone, thus obtaining the active material,
wherein the particle size of the at least one oxygen-containing compound has an average diameter in the range from 10 nm to 40 µm.

Step a) of the process of the invention provides for preparing a solution of a solvent selected from the group consisting of water, ethylene glycole, Dimethyl carbonate, Ethylene carbonate, Diethyl carbonate, Propylen carbonate, glycerin, dimethyl sulfoxide and relative mixtures, preferably water, of at least one oxygen-containing compound selected from Fe₃O₄ and Fe₂O₃, preferably by stirring during the addition of the components. More preferably the addition of the components, while stirring is carried out in sequence.

In a preferred aspect of the process the solution of step a) comprises a further oxygen-containing compound selected from MgO, ZnO, ZrOCl₂, ZrO₂, SiO₂, Bi₂O₃, Al₂O₃, TiO₂ and their mixture, said further oxygen-containing compound having an average diameter in the range from 10 nm to 40 µm.

In step b) the solution of step a) is heated at a temperature range from 75 to 90°C.

After the heating in step c) at least one thickener additive selected from the group consisting of agar agar, xanthan gum, methylcellulose, and arabic gum is added. Further additives can be also added, for example casein. Step c) provides for the addition of agar agar, Xanthan gum and methylcellulose, advantageously in a simultaneous way. After the addition of the at least one thickener additive a homogenous solution is obtained preferably by stirring.

In step d) the homogenous solution of step c) is cooled down to a temperature in the range from 30°C to 15°C, thus obtaining a gelled material.

In step e) the at least one plasticizer additive, for instance silicone, siloxanes or Carnauba Wax, is added, preferably by stirring to the gelled material.

An alternative process for preparing the active material comprises the following steps
i) preparing a first solution with a solvent selected from the group consisting of water, ethylene glycole, Dimethyl carbonate, Ethylene carbonate, Diethyl carbonate, Propylen carbonate, glycerin, dimethyl sulfoxide and Fe₃O₄ and Fe₂O₃ as oxygen-containing compound;
ii) heating the first solution of step i) at a temperature in the range from 90 to 110°C thus obtaining a homogenous solution;
iii) cooling down the homogenous solution of step ii) to a temperature in the range from 50°C to 30°C;
iv) preparing a second solution with a solvent selected from the group consisting of water, ethylene glycole, Dimethyl carbonate, Ethylene carbonate, Diethyl carbonate, Propylen carbonate, glycerin, dimethyl sulfoxide and relative mixtures of at least one thickener additive selected from the group consisting of agar agar, xanthan gum, methylcellulose and arabic gum;
v) heating the second solution of step iv) at a temperature in the range from 90 to 120°C;
vi) mixing the homogenous solution of step iii) at 45°C with solution at step v) thus obtaining a further homogenous solution;
vii) cooling down the further homogenous solution of step vi) to a temperature in the range from 30°C to 20°C and subjecting it to cooling cycles from ambient temperature to -18°C;
viii) adding at least one plasticizer additive to the solution of step vii), thus obtaining a homogenous material solution;
ix) optionally removing the solvent, and obtaining the active material,
wherein the particle size of the at least one oxygen-containing compound has an average diameter in the range from 10 nm to 40 µm.

In a preferred aspect of the process not forming part of the invention the first solution of step i) comprises a further oxygen-containing compound selected from MgO, ZnO, ZrOCl₂, ZrO₂, SiO₂, Bi₂O₃, Al₂O₃, TiO₂ and their mixture, said further oxygen-containing compound having an average diameter in the range from 10 nm to 40 µm.

The steps iv), v) and vi) can optionally be repeated before the mixing step (vii) by preparing a third or more solutions with the addition of a further thickener additive selected from the group consisting of agar agar, xanthan gum, methylcellulose, and arabic gum.

Optional additives such as casein can be added in anyone of the solutions above cited in the process.

The process allows to obtain the active material having a viscosity in the range from 5000 to 100000 centipoise, preferably from 5000 to 40000 centipoise, more preferably from 10000 to 20000 centipoise, as measured with the rotatory viscometer Viscotester VTR5 at rpm =20 at T=25°C.

In another aspect, the invention relates to an electric power generator (EPG) comprising at least two electrodes, placed at a suitable distance from each other. The EPG comprises the active material according to the invention between the at least two electrodes.

The active material and/or the at least one or further oxygen-containing compounds can be placed on at least one electrode according to any suitable known application method in the art, for example doctor blade, electrophoresis, spin-coating, inkjet printing, sol-gel, thermal spray, sputtering, plasma and any physical or chemical vapour deposition techniques.

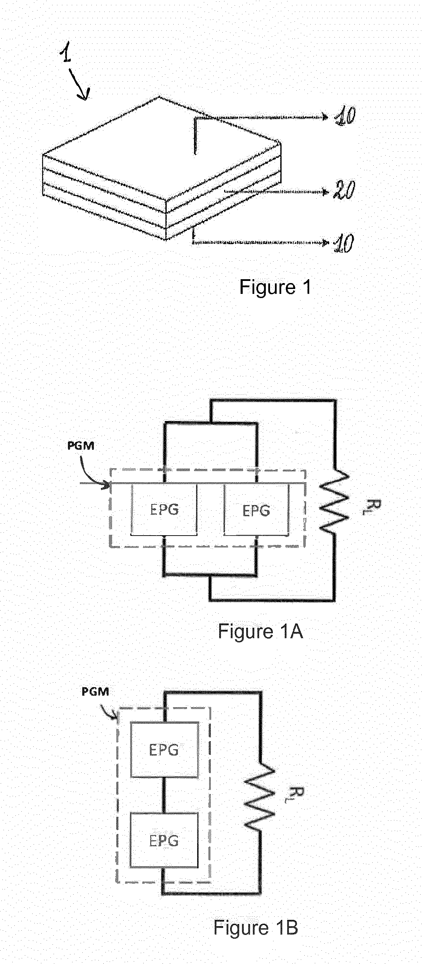

The electrodes are made of metals, alloys and/or carbon-based materials like graphite. Electrodes thickness ranges preferably from 0.1 to 3000 µm, more preferably from 50 to 1000 µm, still more preferably from 300 to 600 µm. In a preferred embodiment of the EPG according to the invention, the at least two electrodes are made of Cu and Al, preferably in form of plates or foils substantially parallel. In case of flexible EPG both self-standing flexible materials (among the previous listed materials) and metallized polymers can be considered as electrodes. In a preferred embodiment of the EPG 1 schematically shown in Fig. 1, the at least two electrodes have a plate-shape. The two plates 10 are arranged substantially parallel each other so as to define a gap filled with the active material 20 of the invention according to a *"sandwich structure".* The distance of the plates 10 depends directly on the desired thickness of the active material to be applied.

The shape of the electrodes is not binding. In an alternative embodiment, for example, the EPG could comprise two coaxial cylindrical electrodes that define an annular space filled with the active material according to the invention. According to the invention, the EPG could comprise more than two electrodes wherein two adjacent electrodes define a gap filled with the active material.

According to a preferred embodiment, the at least two electrodes are made of different material, preferably of Cu and Al. The two at least electrodes are preferably subjected to cleaning and etching prior to be used in the electric power generator of the invention.

The active material is preferably applied on the electrode, by depositing the active material in a thickness from 100 nm to 5 mm. To now, the best results, using a load of 100 Ohm, have been observed with a thickness of 2 mm. On the other hand, the optimal thickness varies depending on the energy required from the device.

The active material can be deposited on the surface of the electrode with doctor blade technique or similar. Once the EPG is assembled with the active material comprised between the at least two electrodes, the EPG is preferably subjected to a heating step, more preferably at about 80°C, in order to obtain a solid sandwich structure.

In a further aspect, the invention relates to a power generator module (PGM) comprising a plurality of EPGs which can be connected in series or parallel. On this regards, Figure 1A shows a circuit comprising a PGM wherein the two EPG are connected in parallel, while Figure 1B shows a circuit comprising a PGM having two EPG connected in series. Both the circuits of Figures 1A and 1B comprise a load resistance R_{L}. The voltage relative to the PGM can be monitored, for example, by connecting a galvanostat parallel to the load resistance R_{L}.

In an even further embodiment of the invention, inventors deem that the proposed active material could be reasonably integrated in the mix of active materials adopted for the manufacturing of commonly used capacitors.

Therefore in another aspect the invention concerns the use of the active material of the invention for manufacturing capacitors.

In view of the properties shown by the active material of the invention, in a still further aspect the invention relates to a use of the active material as dielectric material. As it will be evident from the following experimental part the EPG of the invention is capable to generate current as soon as it has been assembled, thus being a different device from a conventional capacitor. Furthermore and surprisingly, the performances of the EPG of the invention have a strongly dependence on temperature, i.e. potential difference increases with the temperature. In particular, with respect to the traditional power generators of the prior art, the EPG according to the invention does not require a temperature gradient. Indeed, the electric power generator of the invention is able to convert part of the thermal energy in electric energy even an isotherm condition. Specifically and advantageously, the current measured by the electric power generator of the invention increased by a factor of 2-20, increasing the temperature from 20 to 80°C.

Furthermore, as it will also evident from the following experimental part that the EPG is able to supply a capacitor comprised in a suitable electrical circuit. In particular, the latter comprises an EPG according to the invention, a capacitor, a resistor and a switch.

In a first switching state, the switch connects said capacitor in series with said EPG so as to charge the capacitor up to an equilibrium voltage. When the switch is in a second switching state, it connects the capacitor in series with the resistor to discharge the capacitor. In this last condition, the EPG is electrically isolated. When the switch returns in the first switching state, the EPG is ready to charge newly the capacitor for a subsequent charge-discharge cycle.

Advantageously, in the above electrical circuit, the EPG could be replaced by a PGM.

The invention will now be illustrated by some not limitative examples of the active material and of electric power generator of the invention.

### Examples not forming part of the invention Example 1:

### Preparation of the active material

In order to prepare the active material the following components in the respective amounts reported in the below Table 1 were used. Particles size of oxygen-containing compound Fe₃O₄ and Fe₂O₃ had an average diameter in the range from 10 nm to 40 µm, preferably in the range of 1-10 µm, more preferably 2-5 µm as sold by Sigma-Aldrich. The preparation was carried out by using all the above ranges of the particle average diameter and following the same procedure.

**Table 1**

| Components | | Amount |
|---|---|---|
| 1. Demineralized H₂O | | 60-90 % by weight with respect to the total weight of components 1-4 |
| 2. Fe₃O₄ and Fe₂O₃ | Oxygen-containing compound | 1-25% by weight with respect to the total weight of components 1-4 |
| 3. Agar Agar | Thickener additive | 0.1-3.5% by weight with respect to the total weight of components 1-4 |
| 4. Xanthan Gum | Thickener additive | 0.1-2% by weight with respect to the total weight of components 1-4 |
| 5. Methyl cellulose | Thickener additive | 0.1-2% by weight with respect to the total weight of components 1-4 |
| 6. Silicone | Plasticizer additive | 20-60% by weight with respect to the total weight of the gelled material obtained after step d) |

In a Becker demineralized water was poured and stirring was set between 200 and 400 rpm. The stirrer used was "AREX 630W", WELP SCIENTIFICA. In the becker Fe₃O₄ and Fe₂O₃, were added. The solution was then heated up to a temperature in the range from 80 to 90°C. Components Agar Agar, xanthan gum and methyl cellulose were added simultaneously and the stirring was manually continued until an homogeneous solution was obtained. The latter was then left to cool down to ambient temperature at T in the range from 15 to 30°C under manual stirring. A gelled material was obtained. Silicone was then added, and the product was manually stirred until an homogenous active material was obtained.

Without being bound to any theory the inventors deem that fluxing different selected gaseous species during the mixing procedure could enhance the final performances of the as obtained EPG, in terms of OCV, according to the series N₂ > Air (wet) > Air (dry) > O₂ (dry) > CO₂ (dry).

### Example 2:

### Preparation of the active material

In order to prepare the active material the following components in the respective amounts reported in the below Table 2 were used. Particles size of oxygen-containing compounds (Fe₃O₄ and Fe₂O₃, MgO, ZnO, ZrO₂) had an average diameter in the range from 10 nm to 40 µm, preferably in the range of 1-10 µm, more preferably 2-5 µm as sold by Sigma-Aldrich. The preparation was carried out by using all the above ranges of the particle average diameter and following the same procedure.

**Table 2**

| Components | | Amount |
|---|---|---|
| 1. Demineralized H₂O | | 60-90 % by weight with respect to the total weight of components 1-8 |
| 2. Fe₃O₄ and Fe₂O₃ | Oxygen-containing compound | 1-20% by weight with respect to the total weight of components 1-8 |
| 3. MgO | Oxygen-containing compound | 1-15% by weight with respect to the total weight of components 1-8 |
| 4. ZnO | Oxygen-containing compound | 1-7% by weight with respect to the total weight of components 1-8 |
| 5. ZrO₂ | Oxygen-containing compound | 0.1-5% by weight with respect to the total weight of components 1-8 |
| 6. Agar Agar | Thickener additive | 0.1-3.5% by weight with respect to the total weight of components 1-8 |
| 7. Xanthan Gum | Thickener additive | 0.1-2% by weight with respect to the total weight of components 1-8 |
| 8. Methyl cellulose | Thickener additive | 0.1-2% by weight with respect to the total weight of components 1-8 |
| 9. Silicone | Plasticizer additive | 20-60% by weight with respect to the total weight of the gelled material obtained after step d) |

In a Becker demineralized water was poured and stirring was set between 200 and 400 rpm. The stirrer used was "AREX 630W", WELP SCIENTIFICA. In the becker Fe₃O₄ and Fe₂O₃, MgO, ZnO and ZrO₂ were added in sequence, by waiting 5 minutes after adding each component. A final homogeneous aqueous solution was obtained. The solution was then heated up to a temperature in the range from 80 to 90°C. Components Agar Agar, xanthan gum and methyl cellulose were added simultaneously and the stirring was manually continued until a homogeneous solution was obtained. The latter was then left to cool down to ambient temperature at T in the range from 15 to 30°C under manual stirring. A gelled material was obtained. Silicone was then added, and the product was manually stirred until a homogenous active material was obtained.

Without being bound to any theory the inventors deem that fluxing different selected gaseous species during the mixing procedure could enhance the final performances of the as obtained EPG, in terms of OCV, according to the series N₂ > Air (wet) > Air (dry) > O₂ (dry) > CO₂ (dry).

### Example 3

### Preparation of the active material

In order to prepare the active material the following components in the respective amounts reported in the below Table 3 were used. Particles size of oxygen-containing compounds had an average diameter in the range from 10-200 nm, preferably in the range of 15-100 nm, more preferably 20-40 nm as sold by US Research Nanomaterials, Inc. The preparation was carried out by using all the above ranges of the particle average diameter, following the same procedure and adding the following ingredients indicated in table 3.

**Table 3**

| Components | | Amount |
|---|---|---|
| 1. Demineralized H₂O | | 60-90 % by weight with respect to the total weight of components 1-7 |
| 2. Fe₃O₄ and Fe₂O₃ | Oxygen-containing compound | 1-25% by weight with respect to the total weight of components 1-8 |
| 3. Agar Agar | Thickener additive | 0.1-3.5% by weight with respect to the total weight of components 1-7 |
| 4. Xanthan Gum | Thickener additive | 0.1-2% by weight with respect to the total weight of components 1-7 |
| 5. Methyl cellulose | Thickener additive | 0.1-2% by weight with respect to the total weight of components 1-7 |
| 6. Silicone | Plasticizer additive | 20-60% by weight with respect to the total weight of the gelled material obtained after step d) |

In a becker demineralized water was poured and stirring was set between 200 and 400 rpm. The stirrer used was "AREX 630W", WELP SCIENTIFICA. In the becker Fe₃O₄ and Fe₂O₃ were added. A final homogeneous aqueous solution was obtained.

The solution was then heated up to a temperature in the range from 80 to 90°C. Components Agar Agar, xanthan gum and methyl cellulose were added simultaneously and the stirring was manually continued until an homogeneous solution was obtained. The latter was then left to cool down to ambient temperature at T in the range from 15 to 30°C under manual stirring. A gelled material was obtained. Silicone was then added, and the product was manually stirred until a homogenous active material was obtained.

Without being bound to any theory the inventors deem that fluxing different selected gaseous species during the mixing procedure could enhance the final performances of the as obtained EPG, in terms of OCV, according to the series N₂ > Air (wet) > Air (dry) > O₂ (dry) > CO₂ (dry).

### Example 4

### Preparation of the active material

In order to prepare the active material the following components in the respective amounts reported in the below Table 4 were used. Particles size of oxygen-containing compounds had an average diameter in the range from 10-200 nm, preferably in the range of 15-100 nm, more preferably 20-40 nm as sold by US Research Nanomaterials, Inc. The preparation was carried out by using all the above ranges of the particle average diameter and following the same procedure.

**Table 4**

| Components | | Amount |
|---|---|---|
| 1. Demineralized H₂O | | 60-90 % by weight with respect to the total weight of components 1-8 |
| 2. Fe₃O₄ and Fe₂O₃ | Oxygen-containing compound | 1-25% by weight with respect to the total weight of components 1-8 |
| 3. MgO | Oxygen-containing compound | 1-15% by weight with respect to the total weight of components 1-8 |
| 4. ZnO | Oxygen-containing compound | 1-7% by weight with respect to the total weight of components 1-8 |
| 5. ZrO₂ | Oxygen-containing compound | 1-5% by weight with respect to the total weight of components 1-8 |
| 6. Agar Agar | Thickener additive | 0.1-3.5% by weight with respect to the total weight of components 1-7 |
| 7. Xanthan Gum | Thickener additive | 0.1-2% by weight with respect to the total weight of components 1-7 |
| 8. Methyl cellulose | Thickener additive | 0.1-2% by weight with respect to the total weight of components 1-7 |
| 9. Silicone | Plasticizer additive | 20-60% by weight with respect to the total weight of the gelled material obtained after step d) |

In a becker demineralized water was poured and stirring was set between 200 and 400 rpm. The stirrer used was "AREX 630W", WELP SCIENTIFICA. In the becker Fe₃O₄ and Fe₂O₃ and MgO, ZnO, ZrO₂ were added. A final homogeneous aqueous solution was obtained. The solution was then heated up to a temperature in the range from 80 to 90°C. Components Agar Agar, xanthan gum and methyl cellulose were added simultaneously and the stirring was manually continued until a homogeneous solution was obtained. The latter was then left to cool down to ambient temperature at T in the range from 15 to 30°C under manual stirring. A gelled material was obtained. Silicone was then added, and the product was manually stirred until a homogenous active material was obtained.

Without being bound to any theory the inventors deem that fluxing different selected gaseous species during the mixing procedure could enhance the final performances of the as obtained EPG, in terms of OCV, according to the series N₂ > Air (wet) > Air (dry) > O₂ (dry) > CO₂ (dry).

### Example 5:

### Preparation of the active material and preparation of the electric power generator (EPG)

In order to prepare the active material the following components in the respective amounts reported in the below Table 4 were used.

Fe₃O₄ and Fe₂O₃ powder had an average diameter from 10 nm to 40 µm, preferably in the range of 1-10 µm, more preferably 2-5 µm as sold by Sigma-Aldrich. The preparation was carried out by using all the above ranges of the particle average diameter and following the same procedure.

**Table 5**

| Components | | Amount |
|---|---|---|
| 1. Demineralized H₂O | | 60-90% by weight with respect to the total weight of components 1-7 |
| | | |
| 2. Fe₃O₄ and Fe₂O₃ | Oxygen-containing compound | 3-20% by weight with respect to the total weight of components 1-7 |
| 3. Casein | Water coordination additive | 0.1-20% by weight with respect to the total weight of components 1-7 |
| 4. Gum Arabic | Thickener additive | 0.1-5% by weight with respect to the total weight of components 1-7 |
| 5. Agar Agar | Thickener additive | 0.1-8% by weight with respect to the total weight of components 1-7 |
| 6. Xanthan Gum | Thickener additive | 0.1-4% by weight with respect to the total weight of components 1-7 |
| 7. Methyl cellulose | Thickener additive | 0.1-4% by weight with respect to the total weight of components 1-7 |
| 8. Silicone | Plasticizer additive | 20-60% by weight with respect to the total weight of the gelled material |

Here below the detailed description of the operating procedure taking into consideration intermediate amount of each chemical shown in table 5.

A solution 1 was prepared with the ingredients in the following table 6.

**Table 6: ingredients of solution 1**

| **Chemical** | **Amount [g]** |
|---|---|
| Fe₃O₄ and Fe₂O₃ | 150 |
| Casein | 150 |
| Demineralized Water | 1500 |

Fe₃O₄ and Fe₂O₃ and casein reported in table 6 were mixed at ambient temperature until a homogeneous distribution between two solid state substances is reached. After that, demineralized water was added and the solution was heated up to 100°C in a range of time varying from 20 to 40 minutes. The solution was mixed during this procedure to guarantee a complete and proper homogenization. Once the temperature of 100°C is reached, the solution is maintained at this temperature for 5-10 min. The solution was then gradually cooled down to 40°C.

A solution 2 was prepared with ingredients of Table 7

**Table 7: ingredients of solution 2**

| **Chemical** | **Amount [g]** |
|---|---|
| Arabic gum | 50 |
| Demineralized water | 500 |

The solution 2 was heated up to 120°C until the Gum Arabic was completed dissolved. After that, the solution was cooled up to 90°C in order to add agar agar. A solution 2b whose ingredients are reported in Table 8 was obtained.

**Table 8: ingredients of solution 2b**

| **Chemical** | **Amount [g]** |
|---|---|
| Gum Arabic | 50 |
| Demineralized water | 500 |
| Agar Agar | 100 |

The Solution 1 at 40°C was then mixed with Solution 2b at 90°C, thus obtaining Solution 3 (whose ingredients are reported in table 9).

**Table 9: ingredients of solution 3**

| **Chemical** | **Temperature [°C]** |
|---|---|
| Solution 1 | 40 |
| Solution 2b | 90 |

Solution 3 was mixed in order to blend properly the two solutions. This mixture was maintained at 45°C in order to avoid gelation phenomena.

To the solution 3 methyl cellulose and xanthan gum were added, thus obtaining the Solution 4, whose ingredients are reported in table 10:

**Table 10: ingredients of solution 4**

| **Chemical** | **Amount [g]** |
|---|---|
| Fe₃O₄ and Fe₂O₃ | 150 |
| Casein | 150 |
| Demineralized Water | 2000 |
| Gum Arabic | 50 |
| Agar Agar | 100 |
| Methyl cellulose | 30 |
| Xanthan gum | 20 |

This solution 4 was mixed for a minimum of 15 min. After that, Solution 4 was cooled down to ambient temperature for a minimum time period of 4 hours, thus removing any type of mixing action.

As soon as the temperature of 25°C was reached, the Solution 4 was subjected to cooling cycles starting from ambient temperature to -18°C. Once this temperature was reached, Solution 4 was stabilized and maintained at 4°C. After that the solution 4 was weighted and an amount of 50% of its weight of silicone was added and manual agitation was performed in order to obtain an homogenous distribution of the plasticizer.

A solution 5 reported in Table 10b was obtained.

**Table 10b: ingredients of solution 5**

| **Chemical** | **Amount [g]** |
|---|---|
| Fe₃O₄ and/or Fe₂O₃ | 150 |
| Casein | 150 |
| Demineralized Water | 2000 |
| Gum Arabic | 50 |
| Agar Agar | 100 |
| Methyl cellulose | 30 |
| Xanthan gum | 20 |
| Silicone | 1250 |

The solution 5 was used directly to prepare the electric power generator.

Into a beaker containing the solution 5 (table 10b), two aluminum plates (10cm x 10cm) were immersed, at a distance of 1 cm between them. The plates were connected to a 150 W power generator which provides 30 V. The applied potential was maintained until the current reaches a value below 30% of the initial value (5 A for an ideal case), after that the generator was switched off. This procedure allowed to obtain a uniform and homogeneous layer of active material on the aluminum plate connected to the positive pole. This plate was cooled then down to -18°C for 1 hour and then kept at 4°C for 1 hour.

In order to remove the residual water, the plate was heated up in an oven at 80°C. After this step the EPG was built up adding to the aluminum plate, treated as above described, the copper plate. Keeping the EPG at ambient temperature, a small pressure was exerted on it in order to favor the adhesion between each plate and the active material.

The same preparation procedure was carried out employing nanoparticle oxide powders with average diameter in the range from 10-200 nm, preferably in the range of 15-100 nm, more preferably 20-40 nm as sold by US Research Nanomaterials, Inc.

Without being bound to any theory the inventors deem that fluxing different selected gaseous species during the mixing procedure could enhance the final performances of the as obtained EPG, in terms of OCV, according to the series N₂ > Air (wet) > Air (dry) > O₂ (dry) > CO₂ (dry).

### Example 6:

### Preparation of the active material and preparation of the electric power generator (EPG)

In order to prepare the dry active material the following components in the respective amounts reported in the below Table 10 were used.

Fe₃O₄ and Fe₂O₃.powder had an average diameter from 10 nm to 40 µm, preferably in the range of 1-10 µm, more preferably 2-5 µm as sold by Sigma-Aldrich. The preparation was carried out by using all the above ranges of the particle average diameter and following the same procedure.

**Table 11: ingredients of example 6**

| Components | | Amount |
|---|---|---|
| 1. Demineralized H₂O | | 60-90% by weight with respect to the total weight of components 1-7 |
| 2. Fe₃O₄ and/or Fe₂O₃ | Oxygen-containing compound | 4-20% by weight with respect to the total weight of components 1-7 |
| 3. Casein | Water coordination additive | 0.1-20% by weight with respect to the total weight of components 1-7 |
| 4. Gum Arabic | Thickener additive | 0.1-5% by weight with respect to the total weight of components 1-7 |
| 5. Agar Agar | Thickener additive | 0,1-8% by weight with respect to the total weight of components 1-7 |
| 6. Xanthan Gum | Thickener additive | 0,1-4% by weight with respect to the total weight of components 1-7 |
| 7. Methyl cellulose | Thickener additive | 0.1-4% by weight with respect to the total weight of components 1-7 |
| 8. Carnauba Wax | Plasticizer additive | 15-50% by weight with respect to the total weight of the gelled material |

Here below the detailed description of the operating procedure taking into consideration intermediate amount of each chemical shown in table.

The Solution 1 was prepared with the ingredients reported in Table 12:

**Table 12: ingredients of solution 1**

| **Chemical** | **Amount [g]** |
|---|---|
| Fe₃O₄ and Fe₂O₃ | 150 |
| Casein | 150 |
| Demineralized Water | 1500 |

Fe₃O₄ and Fe₂O₃ and casein were mixed at ambient temperature until a homogeneous distribution between two solid state substances was reached. Demineralized water was then added and the solution was heated up to 100°C in a range of time varying from 20 to 40 minutes. The solution was mixed during this procedure to guarantee a complete and proper homogenization. Once the temperature of 100°C was reached, the solution was maintained at this temperature for 5-10 min. The solution was gradually cooled down to 40°C.

The Solution 2 was prepared with the ingredients reported in Table 13.

**Table 13: ingredients of solution 2**

| **Chemical** | **Amount [g]** |
|---|---|
| Arabic gum | 50 |
| Demineralized water | 500 |

The solution 2 was heated up to 120°C until the Arabic gum was completed dissolved. After that, the solution was cooled up to 90°C in order to add agar agar. The solution 2b as reported in Table 14 was so obtained.

**Table 14: ingredients of solution 2b**

| **Chemical** | **Amount [g]** |
|---|---|
| Gum Arabic | 50 |
| Demineralized water | 500 |
| Agar Agar | 100 |

The solution 1 at 40°C was mixed with solution 2b at 90°C, thus obtaining solution 3 (as reported in table 15).

**Table 15: ingredients of solution 3**

| **Chemical** | **Temperature [°C]** |
|---|---|
| Solution 1 | 40 |
| Solution 2b | 90 |

Solution 3 was mixed in order to blend properly the two solutions. This mixture was maintained at 45°C in order to avoid gelation phenomena.

Methyl cellulose and Xanthan gum were then added to the Solution 3, thus obtaining the solution 4:

**Table 16: ingredients of solution 4**

| **Chemical** | **Amount [g]** |
|---|---|
| Fe₃O₄ and Fe₂O₃ | 150 |
| Casein | 150 |
| Demineralized Water | 2000 |
| Gum Arabic | 50 |
| Agar Agar | 100 |
| Methyl cellulose | 30 |
| Xanthan gum | 20 |

The solution 4 (as reported in table 16) was mixed for a minimum of 15 min. After that, solution 4 was cooled down to ambient temperature for a minimum of 4 hours, removing any type of mixing action.

As soon as the temperature of 25°C was reached, the solution 4 was subjected to cooling cycles starting from ambient temperature to -18°C. Once this temperature was reached, the solution 4 was stabilized and maintained at 4°C. After that solution 4 was maintained at ambient temperature for 24 hours.

An amount of 25% by weight with respect to the weight of the solution 4 of properly crumbled carnauba wax was added at ambient temperature to Solution 4 in order to obtain the solution 5 (table 17).

**Table 17: ingredients of solution 5**

| **Chemical** | **Amount [g]** |
|---|---|
| Fe₃O₄ and Fe₂O₃ | 150 |
| Casein | 150 |
| Demineralized Water | 2000 |
| Gum Arabic | 50 |
| Agar Agar | 100 |
| Methyl cellulose | 30 |
| Xanthan gum | 20 |
| Carnauba Wax | 625 |

The solution 5 (Table 17) was heated up to 78°C providing both agitation and ultrasound application. Once solution became homogeneous, the solution 6 was poured on the aluminum plate heated at 78°C too. After this step, the aluminum plate was immersed into a beaker containing Dimethyl Sulfoxide (DMSO) in order to remove the remaining water.

Keeping constant temperature at 78°C, the EPG was built putting in contact the copper plate with the active material.

At this stage, a potential difference of 30 V was applied on EPG for different value of time depending on the temperature:
- 5 minutes for T=78°C
- 5 minutes for T=70°C
- 10 minutes for T=60°C
- 10 minutes for T=50°C
- 10 minutes for T= 40°C
- 30 minutes for T= 30°C
- 10 minutes for T= 25°C
- 30 minutes for T= -18°C

The same preparation procedure was carried out employing nanoparticle oxide powders with average diameter in the range from 10-200 nm, preferably in the range of 15-100 nm, more preferably 20-40 nm as sold by US Research Nanomaterials, Inc. The preparation was carried out by using all the above ranges of the particle average diameter and following the same procedure.

Without being bound to any theory the inventors deem that fluxing different selected gaseous species during the mixing procedure could enhance the final performances of the as obtained EPG, in terms of OCV, according to the series N₂ > Air (wet) > Air (dry) > 02 (dry) > CO₂ (dry).

### Example 7:

### Assembling of an electric power generator having two electrodes.

Two squared electrodes, respectively made of Cu and Al and having the same area (about 4.5 cm²) were cleaned and etched in order to be used for assembling the electric power generator. The active material obtained by the Example 1 using oxides powders with average diameter of 2-5 was then deposited on the surface of Cu electrode with doctor blade technique. The thickness of the active material was about 2 mm and the electrode of Al was placed on top of the deposited active material in a parallel way with respect to the Cu electrode. The two electrodes were gently pressed together assuring a uniform contact of the active material with their own surface. The product so obtained was baked for 20 minutes at 80°C in order to dry the active material, thus obtaining a solid electric power generator. The generator of the invention so obtained was then stored at a temperature from 15 to 18°C for a time period of 12-24 hours before testing it.

The baking process was performed to eliminate the excess water but to guarantee that it still present, as absorbed coordinated water, in a percentage of at least 1% respect to the active material's total mass.

### Example 8

### Electrical characterization of the electric power generator.

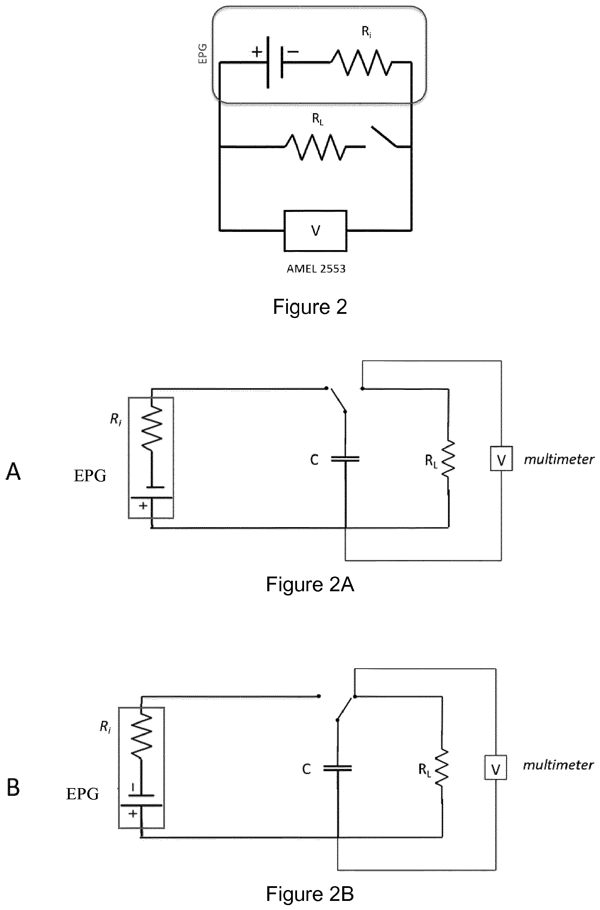

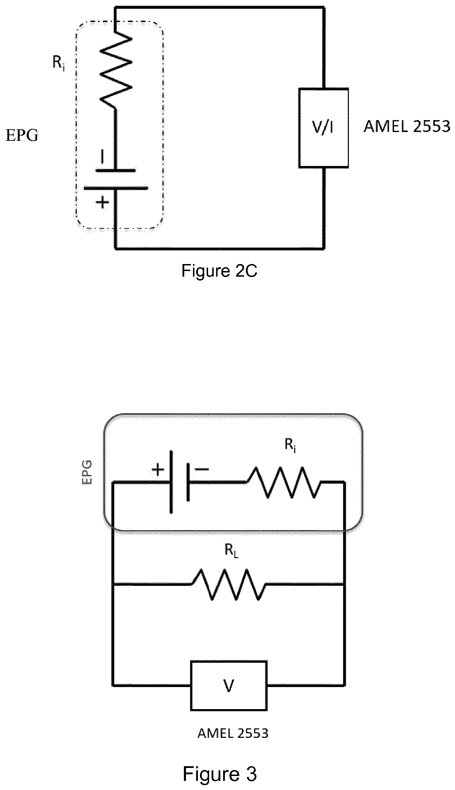

The EPG of Example 7 was electrically characterized by using AMEL2553 potentiostat/galvanostat. The electrical circuit is reported in Figure 2.

From Figure 2, it is shown the EPG is a generator, providing a current in, coupled with its own internal resistance (Ri). The latter is normally defined as a ratio between the open circuit potential and the short circuit current. The load resistance (R_{L}) was connected in series to the electric power generator of Example 7. The voltage was monitored by connecting the galvanostat parallel to the load resistance. The source resistance (Ri) is strongly dependent on the components of the active material. The internal resistance was measured following the *"voltage divider procedure"*: Different load resistances were applied to the EPG until a voltage of an half with respect to the open circuit one was reached after some minutes. In this way, a *"voltage divider"* is created with two equal series load resistances, namely the internal one (Ri) and the load resistance (R_{L}).Through this procedure, the internal resistance (Ri) was estimated to be between 1 and 100 KOhm. The resistance R_{EPG} measured between the electrodes had an average value of 1.2-1.6 MΩ. The active material resulted to have a low conductivity. The electric power generator was characterized by running a potentiometric analysis setting a null current (open voltage). On the contrary, closing the circuit the current flowed through the load resistance (R_{L}).The amount of current was measured from the value of the voltage measured divided by R_{L}=100 Ω.

### Example 9

### Electrical characterization of the electric power generator.

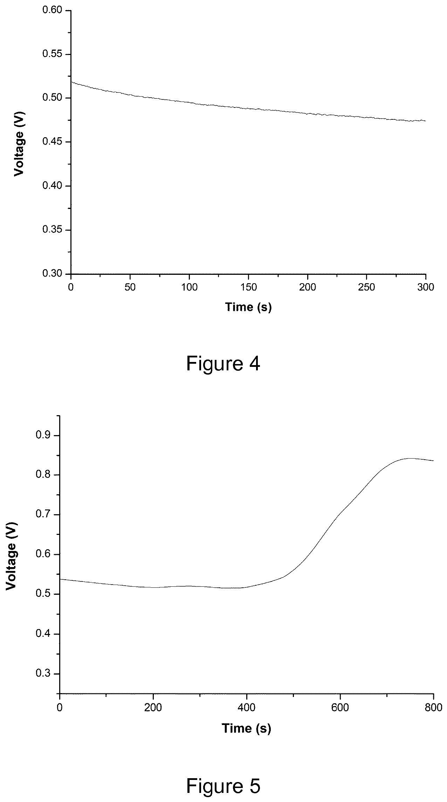

The circuit scheme reported in Figure 2 comprising the electric power generator of Example 7 was tested at ambient temperature (18-20°C). The test consisted in a 5 minutes open voltage measurement. The curve reported in Figure 4 was obtained. Figure 4 is a characteristic curve typical of a condition of *"open circuit"*: The voltage was constant and the average open circuit voltage (OCV) measured for EPG fabricated according to Example 7 was 0.508 V. No current was measured (open circuit) in this test.

### Example 10

### Thermal characterization of the electric power generator.

The circuit scheme reported in Figure 2 comprising the electric power generator of Example 7 was tested for temperature dependence (20-50°C). The test consisted in heating the EPG with the aid of a heater. Temperature was monitored with a thermographic camera (FLIR Exx series). The electric power generator was heated up to 50°C after having let the electric power generator for 400 s at 20°C in the open circuit voltage conditions. After 400 s, the temperature was raise up to 50 °C and maintained constant while the open circuit voltage measurement proceeded. The curve reported in Figure 5 was obtained.

Figure 5 shows the temperature effect on the open circuit voltage: increasing temperature from 20 °C to 50 °C, the voltage increases from 0.518 V at 20 °C to 0.832 V at 50°C, reaching a plateau. Furthermore, heating the EPG at even higher temperatures the voltage can further increase.

### Example 11:

### Thermal characterization of the electric power generator.

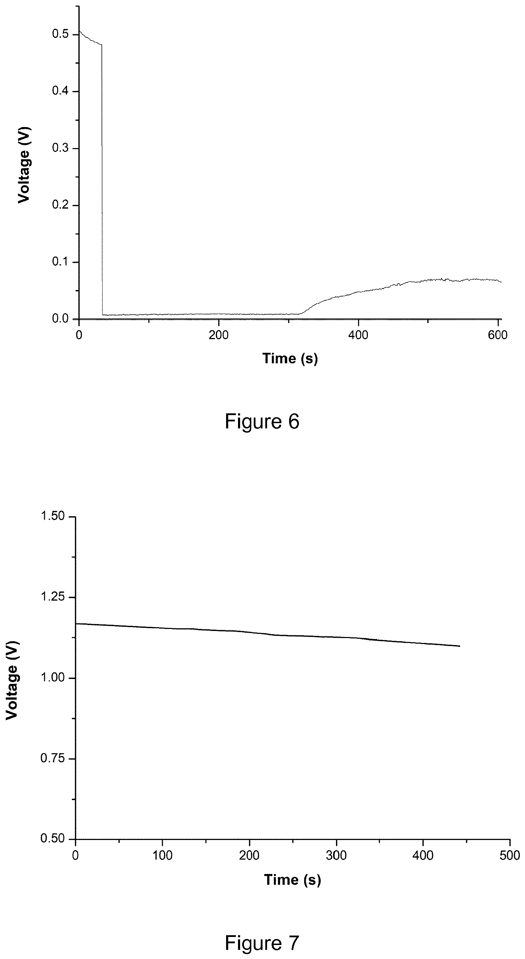

The circuit scheme reported in Figure 3 comprising the electric power generator of Example 7 was tested for temperature dependence (20-50°C). The test consisted in heating the EPG with the aid of a heater. Temperature was monitored with a thermographic camera (FLIR Exx series). The electric power generator was connected to a 100 Ω load at 20 °C and kept in these conditions for five minutes. After this time, the EPG connected to a 100 Ω load was heated up to 50°C and this temperature was kept constant for 300 s. The curves reported in Figure 6 was obtained. The current supplied by the EPG has been calculated by dividing the voltage value for the load value (R_{L}).

After 300 s at 20°C under load, the EPG stabilized at about 8.7 mV corresponding to 0.087 mA, at T=50°C the voltage value increased at about 68 mV corresponding to 0.68 mA. Furthermore, heating the EPG at even higher temperatures the current value can further increase.

### Example 12

A PGM can be obtained assembling multiples EPGs of Example 7 in different combinations. As an example, two EPGs obtained according to Example 7 were connected in series and measured using AMEL 2553 potentiostat/galvanostat by means of open circuit voltage measurement according to Figure 2 at ambient temperature. Results in Figure 7 show that the average open circuit voltage value for two EPGs is equal to 1.148 V. Different configurations can be used. In the first configuration, the EPGs are disposed side by side; the electrodes of different EPGs are not in physical contact but are electrically connected by means of a copper wire. In the second preferred configuration, the EPGs are piled up preferably maintaining the connection wires, preferably putting in contact the surface of copper and aluminum of adjacent EPGs.

### Example13

Particle size of the oxygen-containing compound (Fe₃O₄,Fe₂O₃, MgO, ZnO, ZrO₂) affects the overall performances of the EPG. In fact, the smaller the particles dimension the higher the active surface area for a given material volume. The effect of particle dimension has been investigated comparing EPGs performances for micrometric and nanometric oxygen-containing particles as obtained according to the formulation of Example 1 and Example 3 and following the procedure of Example 7, EPG electrodes area was 4.5 cm². For this purpose, the EPGs have been tested with a potentiostat/galvanostat AMEL2553 according to Figure 2C. The test consisted in applying a discharge current of 2.5 µA; EPGs have been discharged from the nominal voltage to 0.2 V subsequently followed by 45 minutes of rest l=0 µA to evaluate the recovery.

The use of nanoparticle extends the EPG relative lifetime more than 200% with respect to the micrometric formulation. A higher OCV voltage has been also observed.

### Example 14

In another embodiment of the invention, it has been demonstrated that the EPG is capable to supply current, charging a capacitor C comprised in a suitable circuit. As shown in the circuit in Figure 2A is connected in series with a capacitor C with initial voltage Vi=0 V. A "*cell*" can be an EPG (as depicted in Figure 2) or can be a PGM, namely a plurality of EPG connected in series as depicted in Figures 2A and 2B. The cell is connected in series to the capacitor C by a switch SW in a first switching state. During a charge phase (Figure 2A), the EPG charges the capacitor up to an equilibrium voltage. Once the capacitor C is charged, a switch is activated (second switching state) for connecting the capacitor to an arbitrary resistor so as to discharge the capacitor (discharge phase or "rest phase"); the cell is now electrically isolated (Figure 2B). With the term "resistor" is generally meant an electric resistor, a diode, a combination thereof, or any electrical component able to discharge the capacitor C when the switch SW is in said second switching state.

The energy stored in the capacitor C is calculated from characteristic capacity and the charged voltage (Vc), measured by means of a multimeter; a ceramic capacitor is employed in this setup. In one of the test carried out, a temporized switch is used to alternate charge of the capacitor C and the rest phase where the cell is electrically isolated, in this phase voltage cell recover occurs. During this rest phase (configuration B) the capacitor connected in series with an arbitrary resistor (RL) with the only purpose to discharge it completely prior the beginning of the next charge cycle, the discharge curve of the capacitor C is monitored by means of a multimeter.

## Claims

1. An electric power generator (EPG) comprising at least a first electrode (11) and a second electrode (12), wherein the electric power generator comprises an active material between said electrodes (11,12), said active material comprising at least one oxygen-containing compound selected from Fe₃O₄ and Fe₂O₃, at least one thickener additive selected from the group consisting of agar agar, xanthan gum, methylcellulose, and arabic gum, and at least one plasticizer additive, wherein the particle size of the at least one oxygen-containing compound has an average diameter in the range from 10 nm to 40 µm.

2. The electric power generator (EPG) of claim 1 wherein the active material comprises a further oxygen-containing compound selected from MgO, ZnO, ZrOCl₂, ZrO₂, SiO₂, Bi₂O₃, Al₂O₃, TiO₂ and their mixture, said further oxygen-containing compound having an average diameter in the range from 10 nm to 40 µm.

3. The electric power generator (EPG) of claim 1 or claim 2, wherein the at least one oxygen-containing compound and the further oxygen-containing compound have particle average diameter in the range of 20 nm-10 µm, more preferably 10 nm - 5 µm.

4. The electric power generator (EPG) of claim 3, wherein the at least one oxygen-containing compound and the further oxygen-containing compound have particle average diameter in the range from 10 to 200 nm, preferably in the range of 15-100 nm, more preferably 20-40 nm.

5. The electric power generator (EPG) of anyone of claims 1-4, wherein the active material comprises one oxygen-containing compound selected from Fe₃O₄ and Fe₂O₃ in the weight percentage in the range from 3% and 17%, preferably 10% with respect to the total weight of the active material.

6. The electric power generator (EPG) of anyone of claims 1-5, wherein the further oxygen-containing compound is MgO, ZnO, ZrO₂ or a mixture thereof.

7. The electric power generator (EPG) of claim 6, wherein the further oxygen-containing compound is in the range from 0.7% and 20%, preferably 3.7% with respect to the total weight of the active material.

8. The electric power generator (EPG) of anyone of claims 1-7, wherein the at least one plasticizer additive is selected from the group consisting of silicone, siloxanes, carnauba wax, naphtalene, PVDF, parylene PTFE, FEP, PDMS, PVA, latex based suspensions and biopolymers.

9. The electric power generator (EPG) according to anyone of claims 1-4, wherein it comprises Fe₃O₄ and Fe₂O₃, MgO, ZnO, ZrO₂, agar agar, xanthan gum, methylcellulose and silicone.

10. The electric power generator (EPG) according to claims 1-9, wherein said electrodes are made of the different materials.

11. The electric power generator (EPG) according to claims 1-10, wherein said electrodes are made of the same material.

12. The electric power generator (EPG) according to anyone of Claims 1-11, wherein said electrodes are made of a material selected in a group consisting of metals, alloys and carbon based materials.

13. A power generator module (PGM) **characterized in that** it comprises a plurality of electric power generators (EPGs) according to any one of the claims 1-12, wherein said generators are connected in parallel or in series.

14. An electric circuit (EC) comprising an EPG according to any one of the claims 1-12, wherein said circuit (EC) also comprises, a capacitor (C), a resistor (R_{L}) and a switch (SW) and wherein:
- in a first switching state, said switch (SW) connects said capacitor (C) in series with said EPG; and
- in a second switching state, said switch (SW) connects said capacitor (C) in series with said resistor (R_{L}).

15. An electric circuit (EC) comprising a PGM according to claim 13, wherein said circuit (EC) also comprises, a capacitor (C), a resistor (R_{L}) and a switch (SW) and wherein:
- in a first switching state, said switch (SW) connects said capacitor (C) in series with said PGM; and
- in a second switching state, said switch (SW) connects said capacitor (C) in series with said resistor (R_{L}).

## Patentansprüche

1. Stromgenerator (EPG), der mindestens eine erste Elektrode (11) und eine zweite Elektrode (12) umfasst, wobei der Stromgenerator ein aktives Material zwischen den Elektroden (11, 12) umfasst, wobei das aktive Material mindestens einen sauerstoffhaltigen Bestandteil, der aus Fe₃O₄ und Fe₂O₃ gewählt ist, mindestens einen Verdickungszusatz, der aus der Gruppe gewählt ist, die aus Agar-Agar, Xanthan-Gummi, Methylzellulose und Gummiarabicum besteht, und mindestens einen Weichmacherzusatz umfasst, wobei die Partikelgröße des mindestens einen sauerstoffhaltigen Bestandteils einen Durchschnittsdurchmesser im Bereich von 10 nm bis 40 µm aufweist.

2. Stromgenerator (EPG) nach Anspruch 1, wobei das aktive Material einen weiteren sauerstoffhaltigen Bestandteil umfasst, der aus MgO, ZnO, ZrOCl₂, ZrO₂, SiO₂, Bi₂O₃, Al₂O₃, TiO₂ und deren Mischung gewählt ist, wobei der weitere sauerstoffhaltige Bestandteil einen Durchschnittsdurchmesser im Bereich von 10 nm bis 40 µm aufweist.

3. Stromgenerator (EPG) nach Anspruch 1 oder Anspruch 2, wobei der mindestens eine sauerstoffhaltige Bestandteil und der weitere sauerstoffhaltige Bestandteil einen Partikel-Durchschnittsdurchmesser im Bereich von 20 nm bis 10 µm, besonders bevorzugt 10 nm bis 5 µm aufweisen.

4. Stromgenerator (EPG) nach Anspruch 3, wobei der mindestens eine sauerstoffhaltige Bestandteil und der weitere sauerstoffhaltige Bestandteil Partikel-Durchschnittsdurchmesser im Bereich von 10 bis 200 nm, vorzugsweise im Bereich von 15-100 nm, besonders bevorzugt im Bereich von 20-40 nm aufweisen.

5. Stromgenerator (EPG) nach einem der Ansprüche 1-4, wobei das aktive Material einen sauerstoffhaltigen Bestandteil umfasst, der aus Fe₃O₄ und Fe₂O₃ mit einem Gewichtsanteil im Bereich von 3 % bis 17 %, vorzugsweise von 10 % in Bezug auf das Gesamtgewicht des aktiven Materials gewählt ist.

6. Stromgenerator (EPG) nach einem der Ansprüche 1-5, wobei der weitere sauerstoffhaltige Bestandteil MgO, ZnO, ZrO₂ oder eine Mischung daraus ist.

7. Stromgenerator (EPG) nach Anspruch 6, wobei der weitere sauerstoffhaltige Bestandteil im Bereich von 0,7 % bis 20 %, vorzugsweise von 3,7 % in Bezug auf das Gesamtgewicht des aktiven Materials liegt.

8. Stromgenerator (EPG) nach einem der Ansprüche 1-7, wobei der mindestens eine Weichmacherzusatz aus der Gruppe gewählt ist, die aus Silikon, Siloxanen, Karnauba-Wachs, Naphthalin, PVDF, Parylen, PTFE, FEP, PDMS, PVA, latexbasierten Aufschlämmungen und Biopolymeren besteht.

9. Stromgenerator (EPG) nach einem der Ansprüche 1-4, wobei er Fe₃O₄ und Fe₂O₃, MgO, ZnO, ZrO₂, Agar Agar, Xanthan-Gummi, Methylzellulose und Silikon umfasst.

10. Stromgenerator (EPG) nach Anspruch 1-9, wobei die Elektroden aus den unterschiedlichen Materialien bestehen.

11. Stromgenerator (EPG) nach Anspruch 1-10, wobei die Elektroden aus dem gleichen Material bestehen.

12. Stromgenerator (EPG) nach einem der Ansprüche 1-11, wobei die Elektroden aus einem Material bestehen, dass aus einer Gruppe gewählt ist, die aus Metallen, Legierungen und kohlenstoffbasierten Materialien besteht.

13. Stromgeneratormodul (PGM), **dadurch gekennzeichnet, dass** es mehrere Stromgeneratoren (EPGs) nach einem der Ansprüche 1-12 umfasst, wobei die Generatoren parallel oder seriell verbunden sind.

14. Elektrische Schaltung (EC), die einen EPG nach einem der Ansprüche 1-12 umfasst, wobei die Schaltung (EC) außerdem einen Kondensator (C), einen Widerstand (R_{L}) und einen Schalter (SW) umfasst, und wobei:
- in einem ersten Schaltzustand der Schalter (SW) den Kondensator (C) in Reihe mit dem EPG verbindet; und
- in einem zweiten Schaltzustand der Schalter (SW) den Kondensator (C) in Reihe mit dem Widerstand (R_{L}) verbindet.

15. Elektrische Schaltung (EC), die ein PGM nach Anspruch 13 umfasst, wobei die Schaltung (EC) außerdem einen Kondensator (C), einen Widerstand (R_{L}) und einen Schalter (SW) umfasst, und wobei:
- in einem ersten Schaltzustand der Schalter (SW) den Kondensator (C) in Reihe mit dem PGM verbindet; und
- in einem zweiten Schaltzustand der Schalter (SW) den Kondensator (C) in Reihe mit dem Widerstand (R_{L}) verbindet.

## Revendications

1. Générateur de puissance électrique (EPG) comprenant au moins une première électrode (11) et une seconde électrode (12), où le générateur de puissance électrique comprend un matériau actif entre lesdites électrodes (11, 12), ledit matériau actif comprenant au moins un composé contenant de l'oxygène choisi parmi Fe₃O₄ et Fe₂O₃, au moins un additif épaississant choisi dans le groupe constitué par l'agar agar, la gomme xanthane, la méthylcellulose et la gomme arabique, et au moins un additif plastifiant, où la taille des particules du au moins un composé contenant de l'oxygène a un diamètre moyen compris entre 10 nm et 40 µm.

2. Générateur de puissance électrique (EPG) selon la revendication 1, où le matériau actif comprend un autre composé contenant de l'oxygène choisi parmi MgO, ZnO, ZrOCl₂, ZrO₂, SiO₂, Bi₂O₃, Al₂O₃, TiO₂ et leur mélange, ledit autre composé contenant de l'oxygène ayant un diamètre moyen compris entre 10 nm et 40 µm.

3. Générateur de puissance électrique (EPG) selon la revendication 1 ou la revendication 2, où l'au moins un composé contenant de l'oxygène et l'autre composé contenant de l'oxygène ont un diamètre moyen de particule compris entre 20 nm et 10 µm, plus préférablement entre 10 nm et 5 µm.

4. Générateur de puissance électrique (EPG) selon la revendication 3, où l'au moins un composé contenant de l'oxygène et l'autre composé contenant de l'oxygène ont un diamètre moyen de particule compris entre 10 et 200 nm, de préférence compris entre 15 et 100 nm, plus préférablement entre 20 et 40 nm.

5. Générateur de puissance électrique (EPG) selon l'une quelconque des revendications 1 à 4, où le matériau actif comprend un composé contenant de l'oxygène choisi parmi Fe₃O₄ et Fe₂O₃ dans un pourcentage en poids compris entre 3% et 17%, de préférence 10% par rapport au poids total du matériau actif.

6. Générateur de puissance électrique (EPG) selon l'une quelconque des revendications 1 à 5, où l'autre composé contenant de l'oxygène est MgO, ZnO, ZrO₂ ou un mélange de ceux-ci.

7. Générateur de puissance électrique (EPG) selon la revendication 6, où l'autre composé contenant de l'oxygène est compris entre 0,7% et 20%, de préférence 3,7% par rapport au poids total du matériau actif.

8. Générateur de puissance électrique (EPG) selon l'une quelconque des revendications 1 à 7, où l'au moins un additif plastifiant est choisi dans le groupe constitué par le silicone, les siloxanes, la cire de carnauba, le naphtalène, le PVDF, le parylène, le PTFE, le FEP, le PDMS, le PVA, les suspensions à base de latex et les biopolymères.

9. Générateur de puissance électrique (EPG) selon l'une quelconque des revendications 1 à 4, où il comprend Fe₃O₄ et Fe₂O₃, MgO, ZnO, ZrO₂, de l'agar agar, de la gomme xanthane, de la méthylcellulose et du silicone.

10. Générateur de puissance électrique (EPG) selon les revendications 1 à 9, où lesdites électrodes sont faites de matériaux différents.

11. Générateur de puissance électrique (EPG) selon les revendications 1 à 10, où lesdites électrodes sont faites du même matériau.

12. Générateur de puissance électrique (EPG) selon les revendications 1 à 11, où lesdites électrodes sont réalisées en un matériau sélectionné parmi un groupe constitué de métaux, alliages et matériaux à base de carbone.

13. Module générateur de puissance (MGP) **caractérisé en ce qu'**il comprend une pluralité de générateurs de puissance électrique (GPE) selon l'une quelconque des revendications 1 à 12, où lesdits générateurs sont connectés en parallèle ou en série.

14. Circuit électrique (EC) comprenant un EPG selon l'une quelconque des revendications 1 à 12, où ledit circuit (EC) comprend également un condensateur (C), une résistance (R_{L}) et un commutateur (SW) et où :
- dans un premier état de commutation, ledit commutateur (SW) connecte ledit condensateur (C) en série avec ledit EPG ; et
- dans un second état de commutation, ledit commutateur (SW) connecte ledit condensateur (C) en série avec ladite résistance (R_{L}).

15. Circuit électrique (EC) comprenant un PGM selon la revendication 13, où ledit circuit (EC) comprend en outre un condensateur (C), une résistance (R_{L}) et un commutateur (SW) et où :
- dans un premier état de commutation, ledit commutateur (SW) connecte ledit condensateur (C) en série avec ledit PGM ; et
- dans un second état de commutation, ledit commutateur (SW) connecte ledit condensateur (C) en série avec ladite résistance (R_{L}).
